# EUROPÄISCHE PATENTSCHRIFT

(11) **EP 0 742 455 B1**
(45) Veröffentlichungstag und Bekanntmachung des Hinweises auf die Patenterteilung: **12.12.2001**
(21) Anmeldenummer: 95105584.7
(22) Anmeldetag: 13.04.1995
(51) Int. Cl.: G02B 5/18

(54) **Ma stab und Verfahren zur Herstellung eines Ma stabes sowie Positionsmesseinrichtung**
Scale, method of fabricating a scale and a position measuring device
Echelle et méthode de fabrication d'une échelle ainsi qu'un dispositif de mesure de position

(43) Veröffentlichungstag der Anmeldung: 13.11.1996
(73) Patentinhaber: Dr. Johannes Heidenhain GmbH, 83292 Traunreut (DE)
(72) Erfinder: Speckbacher, Peter, Dr., D-84558 Kirchweidach (DE); Flatscher, Georg, Dr., D-83458 Schneizlreuth (DE); Allgäuer, Michael, D-83371 Stein (DE); Bayer, Erich, D-83308 Trostberg (DE); Spanner, Erwin, D-83278 Traunstein (DE); Franz, Andreas, Dr., D-83308 Trostberg (DE)

(56) Entgegenhaltungen:
- EP-A- 0 020 132
- EP-A- 0 160 784
- EP-A- 0 387 520
- US-A- 4 846 552
- US-A- 5 245 471
- SOVIET PATENT ABSTRACTS Section PQ, Week 9351 Derwent Publications Ltd., London, GB; Class P81, AN 93-412829 & SU-A-1 781 657 ( OPTICAL VAVILOV INST) , 15.Dezember 1992

## Beschreibung

Die Erfindung betrifft einen Maßstab in Form eines Phasengitters für eine lichtelektrische Positionsmesseinrichtung gemäß dem Oberbegriff des Anspruches 1 sowie ein Verfahren zur Herstellung eines Maßstabes gemäß Anspruch 10 und eine Positionsmesseinrichtung mit einem derartigen Maßstab gemäß Anspruch 9.

Ein Phasengitter dient bei einer lichtelektrischen Positionsmesseinrichtung zur Messung der Relativlage zweier zueinander beweglicher Objekte als Maßverkörperung.

In der EP 0 160 784 B1 ist ein Phasengitter beschrieben, das aus zwei beabstandeten Reflexionsschichten besteht, die zu beiden Seiten einer transparenten Abstandsschicht angeordnet sind, wobei wenigstens eine Reflexionsschicht als Amplitudengitter ausgebildet ist. Bei allen Ausführungsbeispielen ist die Abstandsschicht als ganzflächig durchgehende gleichmäßig dicke transparente Schicht ausgebildet.

Ein derartiges Phasengitter ist zwar einfach und kostengünstig herstellbar, bei der Verwendung als Beugungsgitter in einer lichtelektrischen Positionsmesseinrichtung hat sich aber gezeigt, dass die Beugungseigenschaften nicht besonders gut sind.

Das Phasengitter gemäß der EP 0 390 092 B1, bei dem auf ein Reliefgitter ganzflächig eine reflektierende Schicht aufgebracht wird, hat zwar gute Beugungseigenschaften, ist aber nicht reproduzierbar.

In der EP 0 020 132 A2 ist eine Belichtungsmaske beschrieben, die zur Durchlichtbelichtung eines Substrats Verwendung findet. Im Bereich der Schlitze sind Metallschichten angeordnet. Diese Metallschichten sind aber für die verwendete Strahlung transparent.

Der Erfindung liegt die Aufgabe zugrunde, einen Maßstab in Form eines Phasengitters anzugeben, das eine einfache Herstellung erlaubt und das gute optische Eigenschaften aufweist.

Diese Aufgabe wird erfindungsgemäß durch die Merkmale des Anspruches 1 gelöst.

Weiterhin soll ein Verfahren zur Herstellung dieses Maßstabs angegeben werden, die Verfahrensschritte hierzu sind im Anspruch 10 angegeben.

Eine Positionsmesseinrichtung mit einem derartigen Maßstab ist im Anspruch 9 angegeben.

Die mit der Erfindung erzielten Vorteile bestehen insbesondere darin, dass nur relativ dünne Reflexionsschichten maßhaltig strukturiert werden müssen, die Stufentiefe vom Strukturierungsprozess aber unbeeinflusst bleibt. Bei dem erfindungsgemäßen Maßstab sind kleine Teilungsperioden mit einfachen Mitteln realisierbar, wobei der Maßstab gute Beugungseigenschaften mit einem hohen Wirkungsgrad besitzt.

Vorteilhafte Ausbildungen der Erfindung entnimmt man den abhängigen Ansprüchen.

Es zeigt
- Figur 1: einen Querschnitt durch ein Phasengitter gemäß der Erfindung,
- Figur 2a-b: Verfahrensschritte zur Herstellung des Phasengitters nach Figur 1.

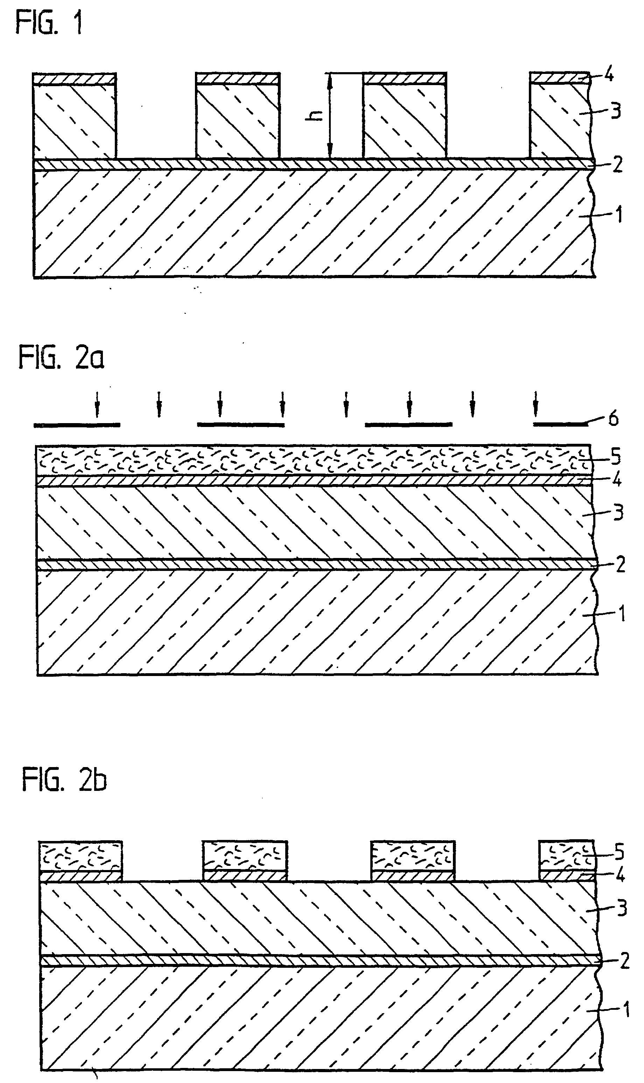

Ein in Figur 1 gezeigtes Phasengitter weist folgenden Schichtaufbau auf. Auf einem Substrat 1 befindet sich eine hochreflektierende dünne Schicht 2. Da das Substrat 1 den Maßstab einer Längenmeßeinrichtung darstellt, ist es vorteilhaft, wenn ein Material hoher Stabilität gewählt wird wie z.B. Quarz, Zerodur oder Stahl. Zerodur hat den Vorteil, daß sich die Länge des Maßstabes bei Temperaturänderungen nur geringfügig ändert. Als reflektierende Schicht eignet sich besonders Chrom oder Gold mit einer Schichtdicke von etwa 30 nm, es kann aber auch eine dünne Titanschicht oder Mehrfachschichten aus Dielektrika verwendet werden.

Die bei einem Phasengitter erforderliche phaenverschiebende Schicht ist strukturiert und wird aus einer etwa 135 nm dicken transparenten Abstandsschicht 3 gebildet. Als Material für diese Schicht 3 eignet sich besonders ein dielektrisches Material wie Siliziumdioxid (SiO₂), Titandioxid (TiO₂), Tantalpentoxid (Ta₂O₅) und Aluminiumoxid (Al₂O₃).

Auf den Stegen der Abstandsschicht 3 ist eine reflektierende Oberflächenschicht 4 aus Chrom in einer Dicke von etwa 30 nm aufgebracht.

Trifft ein Lichtstrahlenbündel auf das Phasengitter, so werden Teilstrahlenbündel auf den Oberflächen der Stege sowie auf den Oberflächen der tiefer liegenden Lücken reflektiert.

Die Phasenverschiebung zwischen den reflektierenden Teilstrahlenbündel ist abhängig von der Wellenlänge λ des auftreffenden Lichtstrahlenbündels sowie von der Stufenhöhe h. Die Stufenhöhe h wird bestimmt aus der Dicke der transparenten Abstandsschicht 3 und der reflektierenden Oberflächenschicht 4. Ein typischer Wert für die gewünschte Phasenverschiebung ist λ/2, wobei sich bei einem in Luft befindlichen Phasengitter eine Stufenhöhe h von (2k-1). λ/4 ergibt, mit k = 1, 2, 3 ... . Üblicherweise wird K = 1 gewählt.

Wie in Figur 2a und 2b dargestellt ist, sind zur Herstellung des Phasengitters gemäß Figur 1 nur wenige und einfache Prozeßschritte erforderlich. In Figur 2a ist das Substrat 1 mit der untersten durchgehenden Reflexionsschicht 2, der transparenten Abstandsschicht 3 und der reflektierenden Oberflächenschicht 4 dargestellt. Dieses Schichtenpaket wird mit einem Photolack 5 beschichtet und durch eine Maske 6 hindurch optisch oder mittels Elektronenstrahllithografie belichtet. Der so strukturierte Photolack 5 dient als Maske für die Ätzung der reflektierenden Oberflächenschicht 4, wie in Figur 2b ersichtlich. Die strukturierte reflektierende Oberflächenschicht 4 dient als Maske für die Ätzung der Abstandsschicht 3 in einem weiteren Ätzschritt. Bei diesem letzten Ätzschritt dient die untere reflektierende durchgehende Schicht 2 als Ätzstoppschicht.

Durch die Strukturierung der transparenten Abstandsschicht wird in überraschender Weise eine besonders gute Beugungseigenschaft des Phasengitters erzielt, wobei gleichzeitig der Vorteil eines spannungsarmen Aufbaus erreicht wird, was sich besonders vorteilhaft bei der Verwendung des Phasengitters in interferentiell arbeitenden Positionsmeßeinrichtungen, wie sie beispielsweise in der EP-0 387 520-B1 angegeben sind, auswirkt. Die Beugungseigenschaften sind besser als bei ganzflächig mit reflektierenden Materialien beschichteten Reliefstrukturen. Der Grund dafür ist die hohe erreichbare Strukturgenauigkeit bei dem erfindungsgemäßen Phasengitter, indem sich ausschließlich auf den parallel zur durchgehenden reflektierenden Schicht 2 verlaufenden Oberflächen der strukturierten Abstandsschicht 3 die weitere dünne reflektierende Oberflächenschicht 4 befindet. Die senkrecht zu dieser Oberfläche verlaufenden Kanten wirken transparent, wobei sich an diesen Kanten der Brechungsindex gegenüber dem umgebenden Medium ändert. Ein besonderer Vorteil besteht weiterhin darin, daß die Stufenhöhe h ausschließlich durch das Abscheiden der Schichten 3 und 4 und nicht durch den Ätzprozeß bestimmt wird. Die Verwendung von dielektrischen Materialien als Abstandsschicht 3 hat den Vorteil, daß dieses Material leichter ätzbar ist als die reflektierenden Schichten 2 und 4, wodurch auch relativ dicke Abstandschichten 3 mit Strukturen im Sub-µm-Bereich mit hoher Kantensteilheit und Strukturgenauigkeit geätzt werden können. Die Abstandsschicht 3 hat eine Dicke, die ein Vielfaches der Dicke der reflektierenden Oberflächenschicht 4 ist. Der Grund für die guten optischen Eigenschaften des erfindungsgemäßen Phasengitters mit einer transparenten Abstandsschicht 3 ist weiterhin, daß die dünne reflektierende Schicht 4 einen geringen Teil des auftreffenden Lichtes hindurchläßt und dieser Anteil erst an der unteren Reflexionsschicht 2 reflektiert wird.

Als Abstandsschicht 3 können auch leicht ätzbare andere Materialien wie Titannitrid (TiN) oder insbesondere nichtreflektierende Metalle eingesetzt werden. Weiterhin kann auf die Schicht 2 als separate Beschichtung verzichtet werden, wenn ein gut reflektierendes Substrat Verwendung findet. Als Substrat könnte hierzu beispielsweise ein poliertes Stahlband eingesetzt werden.

## Patentansprüche

1. Maßstab in Form eines Phasengitters für eine lichtelektrische Positionsmesseinrichtung, bestehend aus einem Substrat (1) mit zwei voneinander beabstandeten Reflexionsschichten (2, 4), die zu beiden Seiten einer Abstandsschicht (3) angeordnet sind, wobei eine Reflexionsschicht (2) als ganzflächig durchgehende Schicht und die andere Reflexionsschicht (4) als Amplitudengitter ausgebildet ist, so dass ein auf den Maßstab auftreffendes Lichtstrahlenbündel auf den beiden Reflexionsschichten (2, 4) reflektiert wird um die Positionsmessung zu erwirken, **dadurch gekennzeichnet, dass** die Abstandsschicht (3) ausschließlich zwischen parallel gegenüberliegenden Bereichen der beiden Reflexionsschichten (2, 4) vorgesehen ist.

2. Maßstab nach Anspruch 1, **dadurch gekennzeichnet, dass** die Abstandsschicht (3) eine Dicke aufweist, die ein Vielfaches der Dicke der als Amplitudengitter ausgebildeten Reflexionsschicht (4) ist.

3. Maßstab nach Anspruch 1, **dadurch gekennzeichnet, dass** die Abstandsschicht (3) aus einem nichtreflektierenden Material besteht.

4. Maßstab nach Anspruch 3, **dadurch gekennzeichnet, dass** die Abstandsschicht (3) aus einem transparenten Material besteht.

5. Maßstab nach Anspruch 4, **dadurch gekennzeichnet, dass** die Abstandsschicht (3) aus einem dielektrischen Material besteht.

6. Maßstab nach Anspruch 5, **dadurch gekennzeichnet, dass** die Abstandsschicht (3) aus Siliziumdioxid besteht.

7. Maßstab nach einem der vorhergehenden Ansprüche, **dadurch gekennzeichnet, dass** die Reflexionsschichten (2, 4) aus Chrom bestehen.

8. Maßstab nach einem der vorhergehenden Ansprüche, **dadurch gekennzeichnet, dass** die ganzflächig durchgehende Reflexionsschicht (2) auf einem Substrat (1) mit geringem Ausdehnungskoeffizienten, insbesondere aus Zerodur aufgebracht.

9. Positionsmesseinrichtung mit einem Maßstab in Form eines Phasengitters, welches aus einem Substrat (1) mit zwei voneinander beabstandeten Reflexionsschichten (2, 4) besteht, die zu beiden Seiten einer Abstandsschicht (3) angeordnet sind, wobei eine Reflexionsschicht (2) als ganzflächig durchgehende Schicht und die andere Reflexionsschicht (4) als Amplitudengitter ausgebildet ist, und bei der zur Positionsmessung ein Lichtstrahlenbündel auf den Maßstab gerichtet ist, dort an den beiden Reflexionsschichten (2, 4) reflektiert und in mehrere Teilstrahlenbündel gebeugt wird und durch Interferenz dieser Teilstrahlenbündel positionsabhängige Abtastsignale erzeugt werden, **dadurch gekennzeichnet, dass** die Abstandsschicht (3) ausschließlich zwischen parallel gegenüberliegenden Bereichen der beiden Reflexionsschichten (2, 4) vorgesehen ist.

10. Verfahren zur Herstellung eines Maßstabs in Form eines Phasengitters nach Anspruch 1, **gekennzeichnet durch** folgende Verfahrensschritte:
a) auf ein Substrat (1) wird die erste durchgehende Reflexionsschicht (2) aufgebracht;
b) auf diese Reflexionsschicht (2) wird ganzflächig die gleichmäßig dicke Abstandsschicht (3) aufgebracht;
c) auf die Abstandsschicht (3) wird ganzflächig die gleichmäßig dicke weitere Reflexionsschicht (4) aufgebracht;
d) auf die weitere Reflexionsschicht (4) wird eine Fotolackschicht (5) aufgebracht, die unter Verwendung einer Belichtungsmaske (6) strukturmäßig belichtet und anschließend entwickelt wird;
e) in einem ersten Ätzprozess wird die weitere Reflexionsschicht (4) an den nicht mit Fotolack (5) beschichteten Bereichen entfernt;
f) in einem zweiten Ätzprozess wird die Abstandsschicht (3) an den nicht mit Fotolack (5) beschichteten Bereichen bis zur ersten Reflexionsschicht (2) entfernt;
g) die Fotolackschicht (5) wird entfernt.

## Claims

1. Scale in the form of a phase grating for a photoelectric position measuring device comprising a substrate (1) with two reflection layers (2, 4) which are at a spacing from each other and are disposed on both sides of a spacing layer (3), one reflection layer (2) being configured as a continuous layer over the entire surface and the other reflection layer (4) being configured as an amplitude grating so that a light beam impinging on the scale is reflected on both reflection layers (2, 4) in order to effect the position measurement, **characterised in that** the spacing layer (3) is provided exclusively between regions of the two reflection layers (2, 4), which regions are parallel and situated opposite each other.

2. Scale according to claim 1, **characterised in that** the spacing layer (3) has a thickness which is a multiple of the thickness of the reflection layer (4) which is configured as amplitude grating.

3. Scale according to claim 1, **characterised in that** the spacing layer (3) is made of a non-reflective material.

4. Scale according to claim 3, **characterised in that** the spacing layer (3) is made of a transparent material.

5. Scale according to claim 4, **characterised in that** the spacing layer (3) is made of a dielectric material.

6. Scale according to claim 5, **characterised in that** the spacing layer (3) is made of silicon dioxide.

7. Scale according to one of the preceding claims, **characterised in that** the reflection layers (2, 4) are made of chrome.

8. Scale according to one of the preceding claims, **characterised in that** the reflective layer (2) which is continuous over the entire surface is applied on a substrate (1) with a low coefficient of expansion, in particular made of Zerodur.

9. Position measuring device having a scale in the form of a phase grating which comprises a substrate (1) with two reflection layers (2, 4) which are at a spacing from each other and are disposed on both sides of a spacing layer (3), one reflection layer (2) being configured as a continuous layer over the entire surface and the other reflection layer (4) being configured as an amplitude grating, and in which a light beam is directed onto the scale for the position measuring, is reflected there on the two reflection layers (2, 4) and is diffracted into a plurality of partial light beams and, by interference of these partial light beams, position-dependent scanning signals are produced, **characterised in that** the spacing layer (3) is provided exclusively between regions of the two reflection layers (2, 4), which regions are parallel and situated opposite each other.

10. Method for producing a scale in the form of a phase grating according to claim 1, **characterised by** the following method steps:
a) the first continuous reflection layer (2) is applied onto a substrate (1);
b) the uniformly thick spacing layer (3) is applied onto this reflection layer (2) over the entire surface;
c) the uniformly thick further reflection layer (4) is applied onto the spacing layer (3) over the entire surface;
d) a photoresist layer (5) is applied onto the further reflection layer (4) and is exposed, using an exposure mask (6) so as to form a structure and then is developed;
e) the further reflection layer (4) at the regions which are not coated with photoresist (5) is removed in a first etching process;
f) the spacing layer (3) at the regions not coated with photoresist (5) is removed as far as the first reflection layer (2) in a second etching process;
g) the photoresist layer (5) is removed.

## Revendications

1. Règle sous la forme d'un réseau de phase pour un dispositif de mesure de position opto-électronique, comprenant un substrat (1) avec deux couches réflectrices (2, 4) mutuellement espacées, qui sont disposées de part et d'autre d'une couche intercalaire (3), une couche réflectrice (2) étant conformée en couche continue, affectant toute la surface, et l'autre couche réflectrice (4) étant conformée en réseau d'amplitude, de telle sorte qu'un faisceau de rayons lumineux arrivant sur la règle soit réfléchi sur les deux couches réflectrices (2, 4) pour former la mesure de position, **caractérisée en ce que** la couche intercalaire (3) est prévue seulement entre des zones parallèles en vis-à-vis des deux couches réflectrices (2, 4).

2. Règle selon la revendication 1, **caractérisée en ce que** la couche intercalaire (3) présente une épaisseur qui est un multiple de l'épaisseur de la couche réflectrice (4) conformée en réseau d'amplitude.

3. Règle selon la revendication 1, **caractérisée en ce que** la couche intercalaire (3) est en un matériau non réfléchissant.

4. Règle selon la revendication 3, **caractérisée en ce que** la couche intercalaire (3) est en un matériau transparent.

5. Règle selon la revendication 4, **caractérisée en ce que** la couche intercalaire (3) est en un matériau diélectrique.

6. Règle selon la revendication 5, **caractérisée en ce que** la couche intercalaire (3) est en dioxyde de silicium.

7. Régle selon une des revendications précédentes, **caractérisée en ce que** les couches réflectrices (2, 4) sont en chrome.

8. Régle selon une des revendications précédentes, **caractérisée en ce que** la couche réflectrice (2) continue, affectant toute la surface, est appliquée sur un substrat (1) à faible coefficient de dilatation, en particulier en Zerodur.

9. Dispositif de mesure de position comportant une règle sous la forme d'un réseau de phase comprenant un substrat (1) avec deux couches réflectrices (2, 4) mutuellement espacées, qui sont disposées de part et d'autre d'une couche intercalaire (3), une couche réflectrice (2) étant conformée en couche continue, affectant toute la surface, et l'autre couche réflectrice (4) étant conformée en réseau d'amplitude, et dans lequel, pour la mesure de position, un faisceau de rayons lumineux est dirigé sur la règle, là est réfléchi sur les deux couches réflectrices (2, 4), est diffracté en plusieurs faisceaux partiels, et des signaux de palpage dépendants de la position sont produits par interférence desdits faisceaux partiels, **caractérisé en ce que** la couche intercalaire (3) est prévue seulement entre des zones parallèles en vis-à-vis des deux couches réflectrices (2, 4).

10. Procédé de fabrication d'une règle sous la forme d'un réseau de phase conformément à la revendication 1,**caractérisé par** les étapes de procédé suivantes:
a) on applique sur un substrat (1) la première couche réflectrice (2) continue, affectant toute la surface;
b) on applique sur cette couche réflectrice (2), sur toute la surface, la couche intercalaire (3) d'épaisseur régulière;
c) on applique sur la couche intercalaire (3), sur toute la surface, la couche réflectrice (4) supplémentaire, d'épaisseur régulière;
d) on applique sur la couche réflectrice (4) supplémentaire une couche de vernis photsensible (5) que l'on expose en utilisant un masque (6) et que l'on développe ensuite;
e) au cours d'une première étape de gravage on élimine la couche réflectrice (4) supplémentaire dans les zones non recouvertes de vernis photsensible (5);
f) au cours d'une seconde étape de gravage on élimine la couche intercalaire (3) dans les zones non recouvertes de vernis photosensible (5), jusqu'à la première couche réflectrice (2);
g) on élimine la couche de vernis photosensible (5);
